# EUROPEAN PATENT APPLICATION

(11) **EP 4 661 612 A1**
(43) Date of publication of application: **10.12.2025**
(21) Application number: 25180186.6
(22) Date of filing: 02.06.2025
(51) Int. Cl.: H05K 7/20

(54) **COOLING SYSTEM WITH FLOW REGULATORS**

(30) Priority: 05.06.2024 GB 202407970
(71) Applicant: Rolls-Royce Deutschland Ltd & Co KG, 15827 Blankenfelde-Mahlow (DE)
(72) Inventor: WANG, Shuai, 15827 Blankenfelde-Mahlow (DE); GAJANAYAKE, Chandana, 15827 Blankenfelde-Mahlow (DE); YEN, Loh Jenn, 15827 Blankenfelde-Mahlow (DE)

(57) **Abstract**

A cooling system (1) comprises: an inlet (10) for a coolant (F), an outlet (11) for the coolant (F) and a plurality of cooling paths (12), via each of which the inlet (10) is in fluid connection with the outlet (11), wherein at least one of the cooling paths (12) is provided with a flow regulator (13A, 13B) configured for regulating a flow of the coolant (F) through the cooling path (12).

## Description

### FIELD

The present disclosure particularly relates to a cooling system and to an electrical device comprising such a cooling system.

### BACKGROUND

Electrical propulsion units for aircrafts allow the use of sustainably generated energy and can be particularly quiet. In addition, electrical propulsion units often only require little maintenance compared to, e.g., combustion engines.

An important aspect is the supply and distribution of electrical power. In the case of electrically driven aircrafts, e.g., converters may be used, e.g., to convert a direct current (DC) from a battery or the like to an alternating current (AC) to drive an electric motor. Further, various electrical devices, e.g., such converters of electrical propulsion units, create considerable amounts of heat. Cooling systems can be used to cool electrical devices.

Electrical devices may have numerous electrical components to be cooled by a cooling system. In order to cool these electrical components, or in order to cool other devices having a plurality of parts to be cooled, the construction of a corresponding cooling system may be complex.

There is need to provide an improved cooling system or at least to provide a useful alternative to known cooling systems.

### SUMMARY

In a first aspect, a cooling system (e.g., for an electrical converter and/or another electrical device) is provided, the cooling system comprising an inlet for a coolant, an outlet for the coolant and a plurality of cooling paths, via each of which the inlet is in fluid connection with the outlet, wherein at least one of the cooling paths is provided with a flow regulator. Therein, the flow regulator is configured for regulating a flow (e.g., a flow rate) of the coolant through the respective cooling path.

This is based on the idea to regulate at least one of the cooling paths individually. This allows to provide a larger amount of coolant per unit of time to a cooling path that is heated more than to a cooling path that is heated less. In this manner a more uniform temperature of cooled components, e.g., electrical components, that emit different amounts of heat is possible with a simple design. The coolant is a fluid and flows from the inlet via the cooling paths to the outlet. The coolant may be gaseous or liquid.

The flow regulator may comprise a flexible tube. This allows to change a cross-sectional area of a passage for the coolant in a simple manner. The flexible tube is hollow. The flexible tube is a hose. The flexible tube may comprise or consist of a plastics material and/or a polymer. The flexible tube may comprise or consist of nylon, polyurethane, polyethylene, PVC, silicone, a synthetic or natural rubber, PTFE or the like.

The flow regulator may comprise an actuating device. The actuating device may be configured for compressing and expanding the flexible tube.

The flow regulator may be configured to expand an inner diameter of the flexible tube when a temperature of the coolant flowing through the at least one of the cooling paths (and/or flow regulator) rises and/or to compress the inner diameter of the flexible tube when the temperature of the coolant flowing through the at least one of the cooling paths (and/or flow regulator) falls. In other words, the flow regulator may adjust the inner diameter of the flexible tube between a first value and a second value, the second value being smaller than the first value, depending on the temperature of the coolant flowing through the flow regulator (and/or the at least one of the cooling paths). Therein, at a first temperature, the inner diameter is adjusted to the first value (e.g., expanded), and at a second temperature the inner diameter is adjusted to the second value (e.g., compressed), wherein the first temperature is larger than the second temperature.

The actuating device of the flow regulator may comprise one or more wires. The actuating device may comprise a wire mesh. This allows a simple actuation.

For example, at least a part of the actuating device of the flow regulator forms a meandering ring. By this, small changes in the configuration of the material of the actuating device allow a substantial change of the inner diameter. The meandering ring may be formed by a wire or other piece of material that follows a serpentine line. The wire or other piece of material may form a closed loop.

Each of the cooling paths has an entrance for the coolant and an exit for the coolant downstream the entrance. The flow regulator may be arranged at the exit of the respective cooling path. This arrangement allows to sense the temperature of the heated coolant directly at the location of the flow regulator. Thereby, the design may be simplified. The flow regulator may be arranged downstream the corresponding cooling path.

The cooling system may comprise an inlet manifold and/or an outlet manifold. The inlet manifold may connect the inlet with the entrances of the cooling paths. The outlet manifold may connect the exits of the cooling paths with the outlet. In this manner, a plurality of cooling paths may be provided, e.g., for a plurality of electrical components.

The flexible tube of the flow regulator defines an inner volume. Therein, the actuating device may surround the inner volume. This allows to simply constrict or open the inner volume. The coolant may flow through the inner volume.

The actuating device of the flow regulator may comprise or consist of a shape memory alloy, SMA. This allows to dispense with an electric actuation and the flow regulator may be self-regulating. That is, a low temperature (of the coolant and, thereby, of the SMA) can lead to a deformation of the actuating device (e.g., into a memory configuration of the SMA). Alternatively, or in addition, a high temperature can lead to a deformation of the actuating device (e.g., into another memory configuration of the SMA). Alternatively, or in addition to an SMA, the actuating device of the flow regulator may comprise or consist of a bimetal, e.g., a bimetallic strip.

That is, the SMA (or other material that changes its shape when the temperature changes) may be configured to expand the actuating device when heated and to compress the actuating device when cooled. The SMA may comprise or consist of copper-aluminium-nickel, nickel-titanium and/or an alloy of zinc, copper, gold and/or iron, e.g., Fe-Mn-Si, Cu-Zn-Al or Cu-Al-Ni.

Alternatively, or in addition, the actuating device of the flow regulator may comprise or consist of a piezoelectric material. This allows a precise control of the coolant flow rate.

The cooling system may further comprise at least one controller and at least one temperature sensor, the at least one temperature sensor being configured for sensing a temperature at the at least one of the cooling paths. The (at least one) controller may be configured for receiving at least one temperature signal from the at least one temperature sensor and for applying a voltage on the piezoelectric material of the actuating device of the flow regulator, e.g., based on the at least one temperature signal, e.g., such that a temperature signal indicating a higher temperature causes a higher (or lower) voltage and a temperature signal indicating a lower temperature (lower than the higher temperature) causes a lower (or higher) voltage, lower (or higher) than the high voltage.

More than one, e.g., each of the cooling paths may be provided with a respective temperature sensor. This allows a fine-tuned flow.

More than one, e.g., each of the cooling paths may be provided with a respective flow regulator configured for regulating a flow of the coolant through the respective cooling path.

The cooling system may comprise a plate. The cooling paths may be formed at, e.g., in, the plate. This allows a efficient cooling with little used space. The plate may be a cold plate.

In a second aspect, an electrical device (e.g., for an electrical propulsion unit) is provided, comprising electrical components and the cooling system of the first aspect. For example, each of the cooling paths of the cooling system are in thermal connection with respective one or more of the electrical components for cooling the corresponding electrical components.

The electrical device may be an electrical converter. The electrical device may comprise an electrical input, an electrical output, and power electronics. The power electronics may be configured to receive electrical power via the input and to provide electrical power via the output. The power electronics may comprise the electrical components. The electrical converter may be configured to convert a direct current, DC, electrical power received at the input into an alternating current, AC, electrical power provided at the output.

In a third aspect, an electrical propulsion unit (e.g., for an aircraft) is provided, comprising an electric machine and the cooling system of the first aspect, or the electrical device of the second aspect.

In a fourth aspect, an aircraft is provided, the aircraft including the cooling system of the first aspect, the electrical device of the second aspect, or the electrical propulsion unit of the third aspect.

### BRIEF DESCRIPTION OF THE DRAWINGS

Exemplary embodiments are now described with reference to the figures, wherein:
**FIG. 1** shows an aircraft in the form of an airplane with electrical propulsion units;
**FIG. 2** shows a block diagram of an electric machine, a battery and an electrical device with a cooling system;
**FIG. 3** shows a plate with a plurality of cooling paths and flow regulators of the cooling system of FIG. 2;
**FIG. 4** shows one of the flow regulators of FIG. 3;
**FIG. 5** shows an actuating device for the flow regulator of FIG. 4 in an expanded state;
**FIG. 6** shows the actuating device of FIG. 5 in a contracted state;
**FIG. 7** shows an actuating device for the flow regulator of FIG. 4 in an expanded state;
**FIG. 8** shows a flow diagram of operations of flow regulators of the cooling system of FIG. 2.

The following table lists the reference numerals used in the drawings with the features to which they refer:

| Ref no. | Feature | Figure |
|---|---|---|
| 1 | Cooling system | 2 |
| 2 | Aircraft | 1 |
| 3 | Electrical device (electrical converter) | 2 |
| 4A-4E | Electrical conductor | 2 |
| 10 | Inlet | 3 |
| 11 | Outlet | 3 |
| 12 | Cooling path | 3 |
| 13A | Flow regulator | 3 4 5 6 |
| 13B | Flow regulator | 7 |
| 14 | Inlet manifold | 3 |
| 15 | Outlet manifold | 3 |
| 16 | Pump | 2 |
| 17 | Temperature sensor | 7 |
| 18 | Controller | 7 |
| 19 | Cooler | 2 |
| 20 | Fuselage | 1 |
| 21 | Wing | 1 |
| 22 | Electrical propulsion unit | 1 |
| 23 | Battery | 2 |
| 30 | Housing | 2 |
| 31 | Electrical input | 2 |
| 32 | Electrical output | 2 |
| 33 | Power electronics | 2 |
| 34 | Motor drive controller | 2 |
| 120 | Entrance | 3 |
| 121 | Exit | 34 |
| 122 | Cavity | 3 |
| 130 | Flexible tube | 4567 |
| 131A | Actuating device | 46 |
| 131B | Actuating device | 7 |
| 132 | Part | 56 |
| 133 | Curve | 56 |
| 134 | Straight section | 56 |
| 220 | Electric machine | 2 |
| 221 | Propeller | 1 |
| 330A | Inverter phase unit | 2 |
| 330B | Inverter phase unit | 2 |
| 330C | Inverter phase unit | 2 |
| 331 | Electrical component | 2 |
| D1 | Inner diameter | 5 |
| D2 | Inner diameter | 6 |
| F | Coolant | 37 |
| L | Line | 2 |
| P | Plate | 2 3 4 |
| S1 | Step | 8 |
| S2A, S2B | Steps | 8 |
| S3A, S3B | Steps | 8 |
| S4A, S4B | Steps | 8 |
| S5 | Step | 8 |
| V | Inner volume | 4 |

### DETAILED DESCRIPTION

Aspects and embodiments of the present disclosure will now be discussed with reference to the accompanying figures. Further aspects and embodiments will be apparent to those skilled in the art.

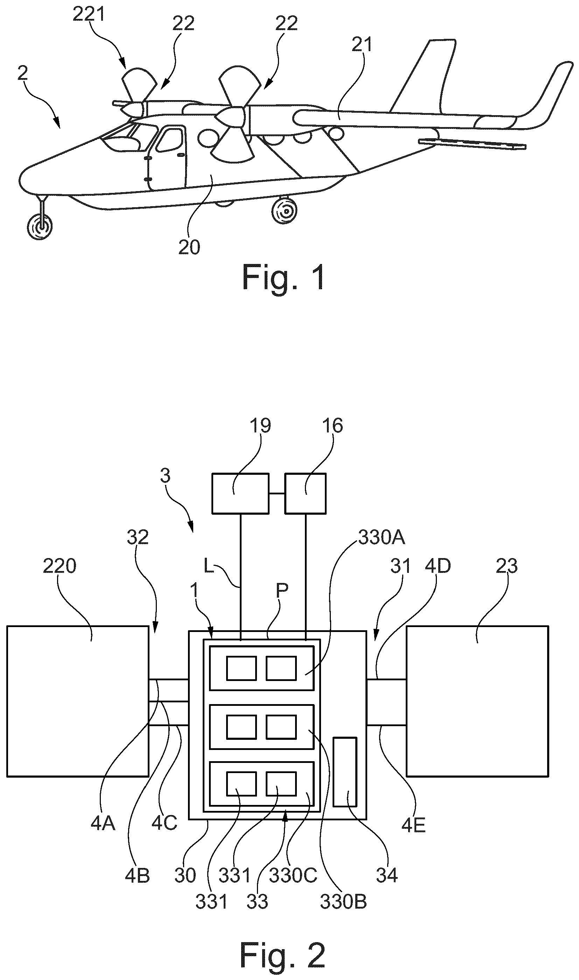

FIG. 1 shows an aircraft 2 in the form of an airplane having a fuselage 20, wings 21 and one or more, in this example two electric propulsion units 22.

The electrical propulsion units 22 each comprise a respective propeller 221. Each of the propellers 221 comprises a plurality of rotor blades, in this example two rotor blades. In alternative embodiments, the aircraft 2 comprises, for example, one or more fans instead of propellers 221 and/or a plurality of propellers, fans, or the like (with more or less rotor blades).

The respective propeller 221 is driven by an electric machine 220 of the corresponding electrical propulsion unit 22, see FIG. 2.

FIG. 2 shows an electrical device in the form of an electrical converter 3 of one of the electrical propulsion units 22. In the present example, the electrical converter 3 is an inverter. The electrical converter 3 is electrically connected with a battery 23 of the aircraft 2. The electrical converter 3 receives electrical energy from the battery 23. In the present example, the battery 23 is mounted in the aircraft 2, e.g., on a central body of the aircraft 2. The electrical converter 3 may be (alternatively or in addition) configured to provide electrical energy to the battery 23.

To receive electrical energy from the battery 23, the electrical converter 3 comprises an electrical input 31. The input 31 comprises two electrical conductors 4D, 4E. The electrical input 31 is a direct current, DC, input.

Further, the electrical converter 3 comprises an electrical output 32. Via the electrical output 32, the electrical converter 3 is electrically connected to the electric machine 220. Here, the electric machine 220 is an electric motor. The electric machine 220 can be a three-phase (e.g., synchronous) machine. Therefore, the electrical output 32 comprises three electrical conductors 4A, 4B, 4C. The electrical output 32 is a three-phase alternating current, AC, output. That is, the electrical converter 3 receives DC from the battery 23, converts it into a three-phase AC and provides the three-phase AC to the electric machine 220. The electric machine 220 may comprise multiple winding sets each with, e.g., three phases.

To provide three (or one or more) phases, the electrical converter 3 comprises power electronics 33 with three inverter phase units 330A, 330B, 330C (or alternatively one or more inverter phase units), one for each of the phases. Each of the inverter phase units 330A, 330B, 330C comprises a plurality of electrical components 331, of which FIG. 2 only depicts few as examples. Here, each of the inverter phase units 330A, 330B, 330C comprises a plurality of electrical components 331 in the form of switches, particularly semiconductor switches such as transistors or the like.

The inverter phase units 330A, 330B, 330C and their electrical components 331 are arranged and mounted in a housing 30 of the electrical converter 3. The housing 30 encloses the power electronics 33.

The electrical converter 3 further comprises a motor drive controller 34. The motor drive controller 34 controls the inverter phase units 330A-330C. Here, the motor drive controller 34 provides PWM (pulse width modulation) signals to the inverter phase units 330A-330C.

The battery 23 is mounted on the aircraft 2, in this example in the fuselage 20. The electric motor 220 and the electrical converter 3 are a part of one of the electrical propulsion units 22 of the aircraft 2. The electrical propulsion units 22 of the aircraft 2 have the same construction.

Further, the electrical converter 3 comprises a cooling system 1. The cooling system 1 is configured for cooling the electrical components 331 of the electrical converter 3.

In the present example, the cooling system 1 comprises a plate P in the form of a cold plate. Within the plate P, a plurality of cooling paths is formed for guiding a coolant, as will be described in greater detail further below. The electrical components 331 are in thermal contact with the plate P. Here, the electrical components 331 are mounted on the plate P. Heat emitted by the electrical components 331 is conducted to the plate P. The coolant is circulated through the plate P via lies L. A pump 16 pumps the coolant through a cooler 19 (e.g., air cooler or other kind of heat sink) and the cooled coolant through the plate P.

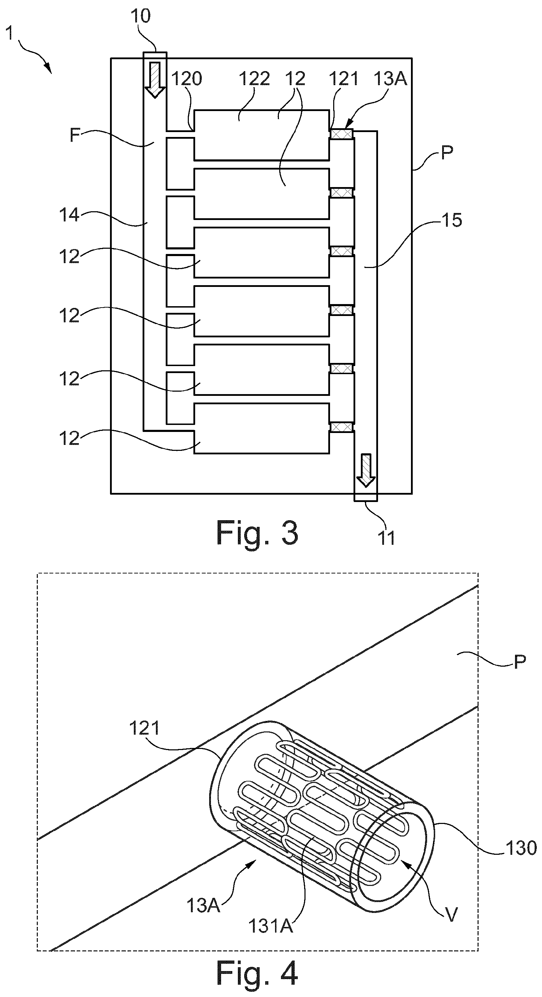

As shown in FIG. 3, the cooling system 1 comprises an inlet 10 for the coolant **F, an** outlet 11 for the coolant F and a plurality of cooling paths 12. The inlet 10 is in fluid connection with the outlet 11 via each of the cooling paths 12. At least one of the cooling paths 12, in the present example each of the cooling paths 12, is provided with a respective flow regulator 13A. The flow regulators 13A are configured for regulating a flow of the coolant F through the respective cooling path 12. Here, the flow regulators 13A are configured for regulating a flow rate (volume and/or mass of coolant F per unit of time) of the coolant F through the respective cooling path 12.

In the present example, the coolant F comprises water, but other liquid or gaseous fluids are also possible.

Each of the cooling paths 12 comprises an entrance 120 and an exit 121. Between the entrance 120 and the exit 121, each cooling path 12 comprises a cavity 122. Coolant F may enter the cavity 122 through the entrance 120 and flow out of the cavity 122 through the exit 121. The cooling paths 12 are arranged in parallel to one another. Here, the cavities 122 are arranged in parallel to one another. The cavities 122 have the same shape, but other designs are also conceivable. The cavity 122 of each cooling path 12 is wider than the corresponding entrance 120, and wider than the corresponding exit 121. For example, one or more electrical components 331 may be in contact with the plate P at the location of a corresponding cavity 122. Here, each of the cavities 122 has a rectangular cross section, but this is only an example. Further, in the present example the cavities 122 have the same shape.

In the present example, the plate P defines six cooling paths 12; however, a different number is also possible, such as two, three or more cooling paths 12.

The plate P further comprises an inlet manifold 14. The inlet manifold 14 connects (in fluid connection) the inlet 10 with each of the entrances 120 of the cooling paths 12. A flow of coolant F flowing through the inlet 10 is divided into a plurality of partial flows that enter the cooling paths 12.

Further, the plate P comprises an outlet manifold 15. The outlet manifold 15 connects (in fluid connection) each of the exits 121 of the cooling paths 12 with the outlet 11. Partial flows of coolant F flowing through the cooling paths 12 are merged to a flow of coolant F through the outlet 11.

The inlet manifold 14 and outlet manifold 15 of this example are passive and comprise no movable parts. For example, each of the inlet manifold 14 and outlet manifold 15 is a tube or other coolant-conducting structure with a plurality of connectors (for connection of the individual cooling paths 12) and the respective inlet 10 or outlet 11.

The flow regulator 13A of each cooling path 12 is arranged at the exit 121 of the respective cooling path 12. The flow regulator 13A of each cooling path 12 is arranged between the exit 121 (and the cavity 122) of the respective cooling path 12 and the outlet manifold 15.

The inlet manifold 14 is arranged downstream (with respect to the flow of the coolant F which, in the present example, is circulating) the inlet 10. The cooling paths 12 are arranged downstream the inlet manifold 14. The outlet manifold 15 is arranged downstream the cooling paths 12. The outlet 11 is arranged downstream the outlet manifold 15.

**FIG. 4** shows a side edge of the plate P and one of the flow regulators 13A abutting at the exit 121 of the respective cooling path 12.

The flow regulator 13A comprises a flexible tube 130 and an actuating device 131A configured for compressing the flexible tube 130 and for expanding the flexible tube 130. In the present example, the actuating device 131A is embedded in the material of the flexible tube 130. The flexible tube 130 has a cylindrical wall. The actuating device 131A is arranged in the material of the cylindrical wall. Here, the actuating device 131A is also cylindrical.

The flexible tube 130 of the flow regulator 13A defines an inner volume V. The actuating device 131A surrounds the inner volume V. The inner volume V makes a fluid connection between the cavity 122 and outlet manifold 15.

The actuating device 131A comprises one or more rings of meandering wire(s). According to FIG. 4, the actuating device 131A comprises two rings of meandering wires.

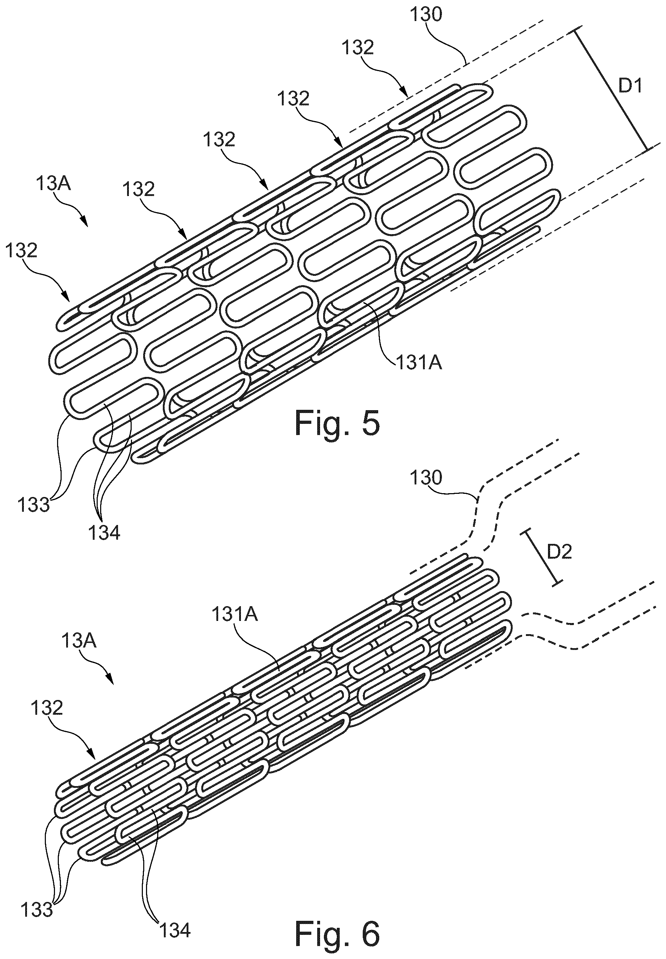

However, as shown in **FIG. 5****,** the actuating device 131A may also comprise more than one of such rings, in the example of FIG. 5 five rings. Each of the rings forms a part 132 of the actuating device 131A. These parts 132 are formed separately of one another, but could alternatively be fixed to one another, e.g., formed in one piece. As shown in FIGS. 5 and 6, the actuating device 131A consists of a wire mesh. The actuating device 131A forms a wire mesh tube. Therein, each wire has straight sections 134 that are connected via curves 133. At least in one configuration of the actuating device 131A, the straight sections 143 of a respective part 132 are parallel to one another. The wire forming one of the parts 132 follows a serpentine line around a central cylinder axis (corresponding to the flow direction of the coolant F through the flow regulator 13A). In other examples, the wires could extend with serpentine lines along the cylinder axis and be fixed to one another (each neighbouring pair) at several positions along the cylinder axis. That is, other mesh structures as the one shown in FIGS. 5 and 6 are possible.

In FIG. 5, the flexible tube 130 is indicated with dashed lines. According to FIG. 5, the flexible tube 130 has an inner diameter D1. The flow regulator 13A is configured to expand the inner diameter D1 of the flexible tube 130 when a temperature of the coolant F flowing through the flow regulator 13A rises and to compress the inner diameter D2 of the flexible tube 130 when the temperature of the coolant F flowing through the flow regulator 13A falls. That is, at a high temperature, the inner diameter D1 is large.

**FIG. 6** shows the actuating device 131A in a compressed state due to a lower temperature. Thereby, the inner diameter D2 of the flexible tube 130 is smaller than at the higher temperature. The SMA deforms when hot and returns to its pre-deform state when cold.

By this, the high temperature leads to a larger flow rate of coolant F through the flow regulator 13A than at the lower temperature, so that the higher temperature directly leads to an increased cooling compared to the flow rate at the lower temperature.

In the example of FIGS. 5 and 6, the actuating device 131A of the flow regulator 13A consists of (or at least comprises) a shape memory alloy, SMA. The SMA may be copper-aluminium-nickel, nickel-titanium and/or an alloy of zinc, copper, gold and/or iron, e.g., Fe-Mn-Si, Cu-Zn-Al or Cu-Al-Ni to name few examples.

The SMA is configured to expand the actuating device 131A and the flexible tube 130 when heated and to compress the actuating device 131A and the flexible tube 130 when cooled. For example, the SMA is trained to assume the expanded, large-diameter D1 state of FIG. 5 when its temperature rises above a predetermined first temperature value. Thereby, a large cross section for coolant F is created and the coolant F flow rate is high. The SMA is also trained to assume the contracted, small-diameter D2 state of FIG. 6 when its temperature falls below a predetermined second temperature value. Thereby, a small (compared with the expanded state) cross section for the coolant F is created and the coolant F flow rate is low.

Alternatively, or in addition, to an SMA, the actuating device 131A could comprise a bimetal, e.g., bimetallic strips, or other thermally expandable material(s). For example, the diameters D1, D2 (obtainable by the different operating conditions of the electrical components 331) differ by at least 20%, 30%, 40% 50% or 100% of D2.

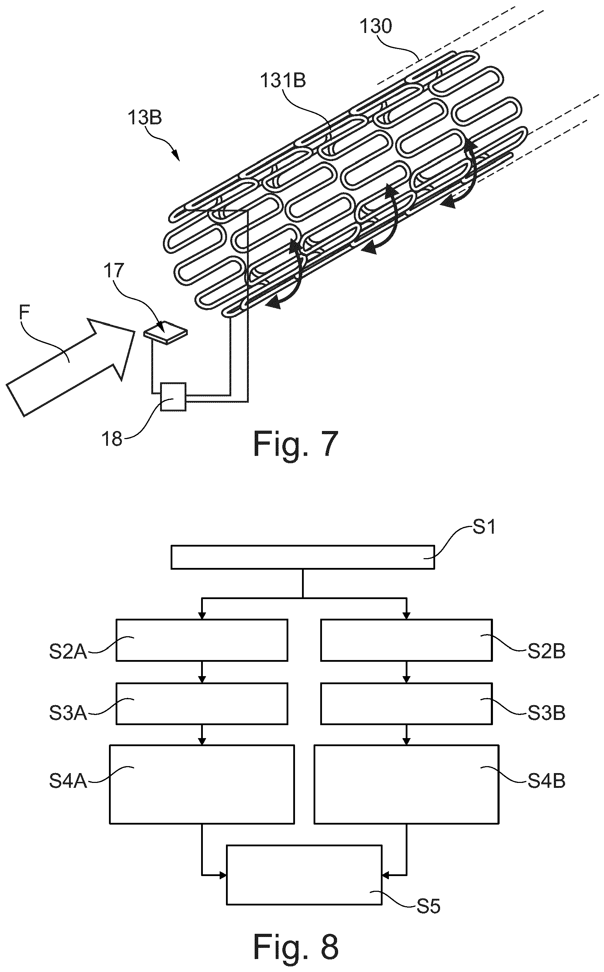

**FIG. 7** shows another Flow regulator 13B with a flexible tube 130 and an actuating device 131B that can be applied to the cooling system 1 instead of, or in addition to, the flow regulator 13A.

In the example of FIG. 7, the actuating device 131B of the flow regulator 13B comprises a piezoelectric material. Further, a controller 18 and a temperature sensor 17 are provided. Here, the controller 18 (e.g., a microprocessor) and the temperature sensor 17 are formed separately but could alternatively be formed in one component.

The temperature sensor 17 is configured for sensing a temperature at the corresponding cooling path 12. For example, the temperature sensor 17 is arranged in or at the flexible tube 130, or in or at the cavity 122, or at an electronic component 331 cooled by the respective cooling path 12. The temperature sensor 17 is configured to sense a temperature associated with the respective cooling path 12. For example, the temperature sensor 17 senses a temperature of coolant F exiting the cavity 122, of a part of the cooling path 12, of an electrical component 331 mounted on the cooling path 12 or of the flow regulator 13B of the cooling path 12. The temperature sensor 17 outputs temperature signals indicative of the sensed temperatures.

The controller 18 is configured to receive the temperature signals from the temperature sensor 17 and to apply a voltage on the piezoelectric material of the actuating device 131B based on the temperature signals. Therein, the controller 18 is configured to translate each temperature signal into a voltage level. By applying the voltage level to the piezoelectric material of the actuating device 131B, the actuating device 131B can be transferred from the contracted state to the expanded state (or vice versa, depending on the polarity).

Each of the cooling paths 12 of the cooling system 1 plate P is provided with a respective flow regulator 13A or 13B (according to FIGS. 5 and 6 or according to FIG. 7) configured for regulating the flow of the coolant F through the respective cooling path 12.

When equipped with the flow regulators 13B according to FIG. 7, each of the cooling paths 12 is provided with an individual temperature sensor 17 (each arranged as described above). One common controller 18 may be provided that reads out all temperature sensors 17 and controls all actuating devices 131B, or each cooling path 12 is provided with an individual controller 18.

**FIG. 8** illustrates a process of balancing temperatures of the cooling paths.

The process starts with step S1 where different amounts of heat are created by the various electrical components 331.

At step S2A, some electrical components 331 create large amounts of heat, so the temperatures of those electrical components 331 increase. In parallel, at step S2B, some other electrical components 331 create small amounts of heat, so the temperatures of those electrical components 331 decrease.

As a result, in step S3A, the coolant F exiting the cooling paths 12 of the electrical components 331 that create large amounts of heat rises. In step S3B, the coolant F exiting the cooling paths 12 of the electrical components 331 that create small amounts of heat drops.

In reaction to these temperatures, the flow regulators 13A, 13B of the high-temperature cooling paths 12 expand the respective diameters of the individual cooling path 12 outlets to allow more coolant F to flow through the respective flow regulator 13A, 13B in step S4A. In parallel, the flow regulators 13A, 13B of the low-temperature cooling paths 12 contract the respective diameters of the individual cooling path 12 outlets to restrict coolant F to flow through the respective flow regulator 13A, 13B in step S4B.

At Step S5, a uniform temperature of the coolant F and of the electrical components 331 are obtained.

The cooling system 1 is configured to perform the process described with reference to FIG. 8. When equipped with the SMA flow regulators 13A, the process is performed autonomously by the temperature-induced deformation of the SMA. When equipped with the piezoelectric flow regulators 13B, the process is performed by the one or more controllers 18.

The flow regulator 13A, 13B forms a thermally expandable valve. The cooling system 1 regulates the coolant F flows towards an equilibrium state where the flow rates in the individual channels are dynamically adjusted according to the heat sources. The cooling efficiency of the cold plate P can therefore be optimized even with varying heat source distributions.

With the described cooling system 1 varying operating conditions (e.g., when different ones of the electrical components 331 are activated and/or operating under high or low load) can be accounted for easily. Therein, the cooling system 1 provides an autonomous flow distribution to regulate the flows through the parallel cooling paths (or channels) by control of the diameter of the individual outlet channels. With different outlet channel diameters, the flow resistances are changed accordingly and hence the coolant F flow rates that pass through the outlet channels. By the uniformed temperatures, the size of the plate P can be decreased.

Notably, the actuating devices 131A, 131B can be configured to be thermally (or electrically) expandable and/or thermally (or electrically) shrinkable.

## Claims

1. A cooling system (1) comprising:
an inlet (10) for a coolant (F);
an outlet (11) for the coolant (F); and
a plurality of cooling paths (12), via each of which the inlet (10) is in fluid connection with the outlet (11), wherein at least one of the cooling paths (12) is provided with a flow regulator (13A, 13B) configured for regulating a flow of the coolant (F) through the cooling path (12).

2. The cooling system (1) of claim 1, wherein the flow regulator (13A, 13B) comprises a flexible tube (130).

3. The cooling system (1) of claim 2, wherein the flow regulator (13A, 13B) comprises an actuating device (131A, 131B) for compressing and expanding the flexible tube (130).

4. The cooling system (1) of claim 3, wherein the flow regulator (13A, 13B) is configured to expand an inner diameter (D1) of the flexible tube (130) when a temperature of the coolant (F) flowing through the flow regulator (13A, 13B) rises and to compress the inner diameter (D2) of the flexible tube (130) when the temperature of the coolant (F) flowing through the flow regulator (13A, 13B) falls.

5. The cooling system (1) of claim 3 or **4,** wherein the actuating device (131A, 131B) of the flow regulator (13A, 13B) comprises a wire mesh and/or at least a part (132) of the actuating device (131A, 131B) of the flow regulator (13A, 13B) forms a meandering ring.

6. The cooling system (1) of any one of claims 3 to 5, wherein each of the cooling paths (12) has an entrance (120) for the coolant (F) and an exit (121) for the coolant (F) downstream the entrance (120), wherein the flow regulator (13A, 13B) is arranged at the exit (121) of the respective cooling path (12), wherein, optionally, an inlet manifold (14) connects the inlet (10) with the entrances (120) of the cooling paths (12) and an outlet manifold (15) connects the exits (121) of the cooling paths (12) with the outlet (11).

7. The cooling system (1) of any one of claims 3 to 6, wherein the flexible tube (130) of the flow regulator (13A, 13B) defines an inner volume (V), wherein the actuating device (131A, 131B) surrounds the inner volume (V).

8. The cooling system (1) of any one of claims 3 to 7, wherein the actuating device (131A) of the flow regulator (13A) comprises or consists of a shape memory alloy, wherein, optionally, the shape memory alloy is configured to expand the actuating device (131A) when heated and to compress the actuating device (131A) when cooled.

9. The cooling system (1) of any one of claims 3 to 7, wherein the actuating device (131B) of the flow regulator (13B) comprises or consists of a piezoelectric material.

10. The cooling system (1) of claim 9, further comprising at least one temperature sensor (17) configured for sensing a temperature at the at least one of the cooling paths (12) and a controller (18), wherein the controller (18) is configured for receiving at least one temperature signal from the at least one temperature sensor (17) and for applying a voltage on the piezoelectric material of the actuating device (131B) of the flow regulator (13B) based on the at least one temperature signal, wherein, optionally, each of the cooling paths (12) is provided with a respective temperature sensor (17).

11. The cooling system (1) of any preceding claim, wherein each of the cooling paths (12) is provided with a respective flow regulator (13A, 13B) configured for regulating a flow of the coolant (F) through the respective cooling path (12) and/or wherein the cooling system (1) comprises a plate (P), wherein the cooling paths (12) are formed in the plate (P).

12. An electrical device (3) comprising:
electrical components (331); and
the cooling system (1) of any preceding claim, wherein each of the cooling paths (12) of the cooling system (1) are in thermal connection with respective one or more of the electrical components (331) for cooling the electrical components (331).

13. The electrical device (3) of claim 12, wherein the electrical device (3) is an electrical converter comprising an electrical input (31), an electrical output (32) and power electronics (33), wherein the power electronics (33) is configured to receive electrical power via the input (31) and to provide electrical power via the output (32), the power electronics (33) comprising the electrical components (331).

14. An electrical propulsion unit (22) for an aircraft (2), the electrical propulsion unit including an electric machine (220) and the cooling system (1) of any one of claims 1 to 11, or the electrical device (3) of claim 12 or 13.

15. An aircraft (2) including the cooling system (1) of any one of claims 1 to 11, the electrical device (3) of claim 12 or 13, or the electrical propulsion unit (22) of claim 14.
